Europäisches Patentamt

European Patent Office

Office européen des brevets

(11) Veröffentlichungsnummer: **0 472 054 A1**

# EUROPÄISCHE PATENTANMELDUNG

(21) Anmeldenummer: **91113277.7**

(22) Anmeldetag: **07.08.91**

(51) Int. Cl.5: **H01L 31/0376**

(30) Priorität: **20.08.90 DE 4026315**

(43) Veröffentlichungstag der Anmeldung:
**26.02.92 Patentblatt 92/09**

(84) Benannte Vertragsstaaten:
**DE FR IT**

(71) Anmelder: **SIEMENS AKTIENGESELLSCHAFT**
**Wittelsbacherplatz 2**
**W-8000 München 2(DE)**

(72) Erfinder: **Birkle, Siegfried, Dr.**
**Veit-Stoss-Strasse 46**
**W-8552 Höchstadt(DE)**
Erfinder: **Kammermaier, Johann, Dr.**
**Ziehrerstrasse 19**
**W-8025 Unterhaching(DE)**
Erfinder: **Rittmayer, Gerhard, Dr.**
**Eskilstunastrasse 8**
**W-8520 Erlangen(DE)**

(54) **Photozelle mit amorphem, wasserstoffhaltigem Kohlenstoff.**

(57) Bei einer Photozelle auf der Basis von Galliumarsenid oder Indiumphosphid befindet sich auf einer Schicht aus p-dotiertem Galliumarsenid (GaAs) bzw. Indiumphosphid (InP) eine Schicht aus amorphem wasserstoffhaltigem Kohlenstoff (a-C:H) mit einer Dicke $\leq 0,1$ $\mu$m, die einen spezifischen elektrischen Widerstand $\geq 10^6$ $\Omega.cm$ besitzt.

EP 0 472 054 A1

Die Erfindung betrifft eine Photozelle auf der Basis von Galliumarsenid oder Indiumphosphid.

Mit Solarzellen aus dem heute gebräuchlichsten Material, kristallines Silicium, werden Spitzenwirkungsgrade um etwa 20 % erreicht. Mit Galliumarsenid beispielsweise sind aufgrund eines höheren Bandabstandes von 1,6 eV bzw. einer besseren Anpassung an die spektrale Verteilung des Sonnenlichts höhere Wirkungsgrade möglich, nämlich bis zu 26 % (siehe dazu: "Siemens-Energietechnik", 2. Jahrg. (1980), S. 266-269). Bei der Herstellung derartiger Photozellen sind folgende Probleme zu lösen:

- Oberflächenschutz, d. h. Passivierung, der Halbleiterstruktur gegen chemische Einflüsse und mechanische Einwirkung;
- Entspiegelung der Oberfläche;
- Erzeugung einer Raumladungszone zur Ladungsträgertrennung (pn-Übergang oder Schottkybarriere).

Photozellen auf der Basis von Galliumarsenid bzw. Indiumphosphid erfordern zur Erzeugung von pn-Übergängen eine sehr hohe Dotierung des Halbleiters, die technisch sehr aufwendig und risikobehaftet ist (Isolationsausfälle); Schottkybarrieren, die durch den Kontakt Metall/Halbleiter realisiert werden, absorbieren das einfallende Licht oder haben einen zu hohen Widerstand. Die Passivierung derartiger Photozellen erfolgt nach dem derzeitigen Stand der Technik mit Hilfe von Kunststoffschichten, deren Feuchtesperrvermögen aber begrenzt ist, oder mit Glas, wobei allerdings ein Verkleben erforderlich ist.

Aufgabe der Erfindung ist es, Photozellen der eingangs genannten Art in der Weise auszugestalten, daß sie technologisch einfach herstellbar und und gleichzeitig chemisch geschützt sind.

Dies wird erfindungsgemäß dadurch erreicht, daß sich auf einer Schicht aus p-dotiertem Galliumarsenid (GaAs) bzw. Indiumphosphid (InP) eine Schicht aus amorphem wasserstoffhaltigem Kohlenstoff (a-C:H) mit einer Dicke ≤ 0,1 $\mu$m befindet, die einen spezifischen elektrischen Widerstand ≥ $10^6$ Ω.cm besitzt.

Zur Realisierung von Photozellen nach der Erfindung dienen somit a-C:H/GaAs- bzw. a-C:H/InP-Heterostrukturen; diese Heterostrukturen weisen eine Grenzfläche mit wenig Rekombinationszentren auf.

Die a-C:H-Schicht ist intrinsisch n-leitend. Auf diese Weise ergibt sich bei Heterostrukturen der genannten Art im Bereich der Grenzfläche zwischen den beiden Halbleitern - ohne n-Dotierung - eine photovoltaisch wirksame Raumladungszone mit geringer Rekombinationsgeschwindigkeit. Bei einer a-C:H-Schichtdicke, die unter der Diffusionslänge für Ladungsträger liegt, treten Ladungsträgerverluste durch Rekombination nicht mehr auf, so daß für das eingestrahlte Licht eine hohe, nahe bei 1 liegende Quantenausbeute erreicht wird.

Amorpher wasserstoffhaltiger Kohlenstoff, kurz a-C:H, ist ein Kohlenstoffmaterial, bei dem ein amorphes Kohlenstoffnetzwerk vorliegt. Diese Modifikation von Kohlenstoff erhält ihre besonderen Eigenschaften, wie chemische Resistenz und elektrische Isolation, durch das Nebeneinander von tetraedrischer ($sp^3$) und trigonaler ($sp^2$) Hybridisierung; die amorphe Struktur wird durch den Einbau von Wasserstoff (etwa 10 bis 40 Atom-%) stabilisiert. Dieser Wasserstoff ist außerdem chemisch fest gebunden, so daß der Staebler-Wronski-Effekt, wie dies beispielsweise in a-Si:H der Fall ist, nicht auftreten kann.

Die Photozellen nach der Erfindung weisen eine a-C:H-Schicht mit einem spezifischen elektrischen Widerstand ≥ $10^6$ Ω.cm auf; vorzugsweise beträgt der spezifische elektrische Widerstand ≤ $10^9$ Ω.cm. Das Halbleitermaterial, d. h. GaAs bzw. InP, liegt vorteilhaft in monokristalliner Form vor.

Zur Herstellung von Photozellen nach der Erfindung bzw. von a-C:H/Halbleiter-Heterostrukturen wird auf ein Substrat aus monokristallinem, polykristallinem oder amorphem Galliumarsenid bzw. Indiumphosphid eine a-C:H-Schicht mit einer Dicke bis zu 0,1 $\mu$m aufgebracht. Die a-C:H-Abscheidung erfolgt durch eine Hochfrequenz-Niederdruck-Plasmaabscheidung gasförmiger Kohlenwasserstoffe, gegebenenfalls in Gegenwart von Wasserstoff. Dabei lassen sich die intrinsischen elektrischen und optischen Eigenschaften von a-C:H durch die Plasmabedingungen in einem relativ weiten Bereich steuern und können somit den jeweiligen Erfordernissen angepaßt werden. In üblicher Weise wird dann auf die Rückseite der Halbleiterschicht aus p-dotiertem GaAs bzw. InP noch eine Kontaktschicht aufgebracht, die Vorderseite der a-C:H-Schicht wird mit einer transparenten Elektrode, beispielsweise einer ITO-Elektrode, versehen.

Für die Abscheidung der a-C:H-Schicht gelten vorzugsweise folgende Bedingungen:

- Druck: ≤ 50 Pa
- Leistungsdichte: ≤ 5 W.cm$^{-2}$
- DC-self-bias-Spannung: < -800 V.

Für die Herstellung einer a-C:H/Halbleiter-Heterostruktur mit einer im Bereich der Grenzfläche photovoltaisch wirksamen Raumladungszone ist von entscheidender Bedeutung, daß - aufgrund des nicht-thermischen Charakters der a-C:H-Abscheidung - in der Grenzfläche Bindungsverhältnisse erzielt werden können, die mit thermischen Prozessen nicht realisierbar sind. Dies trägt dazu bei, daß in der dünnen a-C:H-Schicht und in der Grenzfläche zum GaAs bzw. InP eine Rekombination von durch Photonen erzeugten Ladungsträgerpaaren nicht erfolgen kann. In dieser Hinsicht wirkt sich auch günstig aus, wenn die Halbleiteroberfläche - vor der a-C:H-Abscheidung - einer Plasmavorbehandlung, beispielsweise mit Argon oder Wasserstoff, unterworfen wird; auf diese Weise werden störende Fremdbestandteile, insbesondere Oxide, beseitigt. Bei einem derartigen Vorgehen eventuell entstehende freie Valenzen werden durch die nachfolgend abgeschiedene a-C:H-Schicht abgesättigt, wenn die Halbleiteroberfläche von Luft freigehalten wird.

Aufgrund des sehr niedrigen $H_2O$-Permeationskoeffizienten (siehe dazu EP-OS 0 381 109) sind die a-C:H/Halbleiter-Heterostrukturen der Photozellen nach der Erfindung automatisch passiviert. Vorzugsweise weisen die a-C:H-Schichten einen $H_2O$-Permeationskoeffizienten $< 5.10^{-13}$ $m^2.s^{-1}$ auf. Wegen der hohen Brechzahl tragen die a-C:H-Schichten in den Photozellen ferner auch wesentlich zur Entspiegelung bei.

Heterostrukturen nach der Erfindung mit monokristallinem Halbleitermaterial sind hinsichtlich der Responsivität vergleichbar mit kristallinem Silicium. Im Vergleich zu bekannten Photozellen auf GaAs- bzw. InP-Basis ist bei den Photozellen nach der Erfindung der technologische Aufwand wesentlich geringer.

Anhand eines Ausführungsbeispiels soll die Erfindung noch näher erläutert werden.

Auf ein p-dotiertes Substrat aus monokristallinem GaAs mit einer Ladungsträgerkonzentration von annähernd $10^{18}$ $cm^{-3}$, das einer Vorbehandlung in einem Argon- oder Wasserstoffplasma (unter den nachfolgend beschriebenen Bedingungen bezüglich Druck und Leistung) unterzogen wurde, wird eine 0,1 $\mu m$ dicke a-C:H-Schicht abgeschieden. Die Plasmaabscheidung erfolgt mit RF-Anregung (RF = Radiofrequenz) und einer sich infolge einer kapazitiven Energieeinkopplung ausbildenden DC-self-bias-Spannung; als Prozeßgas dient Methan, der Arbeitsdruck beträgt 20 Pa. Bei einer Plasmaleistungsdichte von 2,5 $W.cm^{-2}$ auf der Substratfläche und einer DC-self-bias-Spannung von -900 V wird eine a-C:H-Schicht mit einem optischen Bandabstand von 0,9 eV, einem spezifischen elektrischen Widerstand von $5.10^7$ $\Omega.cm$ und einem $H_2O$-Permeationskoeffizienten von ca. $10^{-13}$ $m^2.s^{-1}$ erhalten; im Vergleich dazu liegt der $H_2O$-Permeationskoeffizient beispielsweise bei Polyimid etwa bei $10^{-10}$ $m^2.s^{-1}$.

Die Messung der Photoleitung (Meßspannung: 5 V) an der erhaltenen a-C:H/GaAs-Heterostruktur ergibt im spektralen Bereich von 500 bis 900 nm eine Responsivität R zwischen 0,3 und 0,45 $A.W^{-1}$. Nach der Beziehung

$$R = \frac{e \cdot \eta}{h \cdot \nu}$$

(siehe dazu: R. Müller "Bauelemente der Halbleiter-Elektronik", 3. Auflage (1987), Springer-Verlag, S. 48 und 49) ergibt sich daraus für die wellenlängenabhängige Quantenausbeute $\eta$ ein Wert von 0,4 bis nahezu 1.

**Patentansprüche**

1. Photozelle auf der Basis von Galliumarsenid oder Indiumphosphid, **dadurch gekennzeichnet,** daß sich auf einer Schicht aus p-dotiertem Galliumarsenid (GaAs) bzw. Indiumphosphid (InP) eine Schicht aus amorphem wasserstoffhaltigem Kohlenstoff (a-C:H) mit einer Dicke $\leq$ 0,1 $\mu m$ befindet, die einen spezifischen elektrischen Widerstand $\geq 10^6$ $\Omega.cm$ besitzt.

2. Photozelle nach Anspruch 1, **dadurch gekennzeichnet,** daß der spezifische elektrische Widerstand der a-C:H-Schicht $\leq 10^9$ $\Omega.cm$ beträgt.

3. Photozelle nach Anspruch 1 oder 2, **dadurch gekennzeichnet,** daß monokristallines GaAs bzw. InP vorliegt.

4. Photozelle nach einem der Ansprüche 1 bis 3, **dadurch gekennzeichnet,** daß die a-C:H-Schicht einen $H_2O$-Permeationskoeffizienten $< 5.10^{-13}$ $m^2.s^{-1}$ besitzt.

5. Photozelle nach einem oder mehreren der Ansprüche 1 bis 4, **dadurch gekennzeichnet,** daß die a-C:H-Schicht durch eine Hochfrequenz-Niederdruck-Plasmaabscheidung gasförmiger Kohlenwasserstoffe hergestellt ist.

| Europäisches Patentamt | EUROPÄISCHER RECHERCHENBERICHT | Nummer der Anmeldung |
| | | EP 91 11 3277 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | JOURNAL OF APPLIED PHYSICS Band 62, Nr. 9, 1. November 1987, Seiten 3799-3802, New York, NY, US; K. NODA et al.: "Photoconduction of the a-Si:H/a-C:H heterostructure" <br> * ganzes Dokument * <br> – – – | 1,3-5 | H 01 L 31/0376 |
| A | idem <br> – – – | 4 | |
| Y | JOURNAL OF APPLIED PHYSICS Band 54, Nr. 8, August 1983, Seiten 4590-4595, New York, NY, US; A. BUBENZER et al.: "rf-plasma deposited amorphous hydrogenated hard carbon thin films: Preparation, properties, and applications" <br> * ganzes Dokument * <br> – – – | 1,3-5 | |
| A | idem <br> – – – | 4 | |
| A | CHEMICAL ABSTRACTS Band 103, 1985, Seite 535, rechte Spalte, Zusammenfassung Nr. 223423m, Columbus, Ohio, US; J.J. POUCH et al.: "Optical properties of hydrogenated amorphous carbon films grown from methane plasma" & Mater. Res. Soc. Symp. Proc. 1985, Band 47, Seiten 201-204 <br> * Zusammenfassung * <br> – – – | 1,3 | |
| D,A | EP-A-0 381 109 (SIEMENS) <br> * Spalte 2, Zeile 26 - Spalte 5, Zeile 46 * <br> – – – | 4,5 | **RECHERCHIERTE SACHGEBIETE (Int. Cl.5)** <br><br> H 01 L |
| D,A | SIEMENS ENERGIETECHNIK Band 2, Heft 7, 1980, Seiten 266-269, Siemens, München, DE; G.H. WINSTEL: "Elektrische Energie aus Solarzellen" <br> * ganzes Dokument * <br> – – – – – | 1-5 | |

Der vorliegende Recherchenbericht wurde für alle Patentansprüche erstellt

| Recherchenort | Abschlußdatum der Recherche | Prüfer |
|---|---|---|
| Berlin | 28 Oktober 91 | MUNNIX S J G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument
-------------------------------------------------------------
& : Mitglied der gleichen Patentfamilie, übereinstimmendes Dokument